(19) **Europäisches Patentamt** / **European Patent Office** / **Office européen des brevets**

(11) **EP 1 202 291 B1**

(12) # EUROPÄISCHE PATENTSCHRIFT

(45) Veröffentlichungstag und Bekanntmachung des Hinweises auf die Patenterteilung:
**05.09.2007 Patentblatt 2007/36**

(51) Int Cl.:
***G21K 1/06*** *(2006.01)*

(21) Anmeldenummer: **01123195.8**

(22) Anmeldetag: **28.09.2001**

(54) **Beleuchtungssystem mit einem Gitterelement**

Illumination system with a grid unit

Système d'illumination avec une grille

(84) Benannte Vertragsstaaten:
**DE FR GB IT NL**

(30) Priorität: **06.06.2001 DE 10127298**
**29.09.2000 US 679718**
**26.01.2001 DE 10103738**

(43) Veröffentlichungstag der Anmeldung:
**02.05.2002 Patentblatt 2002/18**

(73) Patentinhaber: **Carl Zeiss SMT AG**
**73447 Oberkochen (DE)**

(72) Erfinder:
• **Weiss, Markus, Dr.**
**73430 Aalen (DE)**
• **Singer, Wolfgang, Dr.**
**73431 Aalen (DE)**
• **Kleemann, Bernd**
**73439 Aalen (DE)**
• **Wedowski, Marco**
**73431 Aalen (DE)**

(74) Vertreter: **Sawodny, Michael-Wolfgang**
**Adolf - Lüken - Höflich - Sawodny,**
**Dreiköniggasse 10**
**89073 Ulm (DE)**

(56) Entgegenhaltungen:
**US-A- 6 118 577          US-B1- 6 233 056**

• **PATENT ABSTRACTS OF JAPAN Bd. 1996, Nr. 03, 29. März 1996 (1996-03-29) -& JP 07 301696 A (HITACHI LTD), 14. November 1995 (1995-11-14)**
• **FUKUDA H ET AL: "Design and analysis of diffraction mirror optics for EUV projection lithography" MICROELECTRONIC ENGINEERING, ELSEVIER PUBLISHERS BV., AMSTERDAM, NL, Bd. 27, Nr. 1, Februar 1995 (1995-02), Seiten 239-242, XP004025073 ISSN: 0167-9317**
• **WILKINSON E ET AL: "FIRST-GENERATION HOLOGRAPHIC, GRAZING-INCIDENCE GRATINGS FOR USE INCONVERGING, EXTREME-ULTRAVIOLET LIGHT BEAMS" APPLIED OPTICS, OSA, OPTICAL SOCIETY OF AMERICA, WASHINGTON, DC, US, Bd. 34, Nr. 22, 1. August 1995 (1995-08-01), Seiten 4685-4695, XP000518145 ISSN: 0003-6935**

**EP 1 202 291 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die Erfindung betrifft ein Beleuchtungssystem für Wellenlängen ≤ 100 nm, wobei das Beleuchtungssystem, eine Objektebene und eine Feldebene aufweist. Bei Beleuchtungssystemen ≤ 100 nm besteht das Problem, daß die Lichtquellen derartiger Beleuchtungssysteme Strahlung emittiert, die zu einer unerwünschten Belichtung des lichtsensitiven Objektes in der Waferebene führen kann und zudem optische Komponenten des Belichtungssystemes, wie beispielsweise die Multilayer-Spiegel hierdurch erwärmt werden.

Zum Ausfiltern der unerwünschten Strahlung werden in Beleuchtungssystemen für Wellenlängen ≤ 100 nm Transmissionsfilter, verwandt. Derartige Filter haben den Nachteil hoher Lichtverluste. Desweiteren können sie sehr leicht durch Wärmebelastung zerstört werden.

Aufgabe der Erfindung ist es, ein Beleuchtungssystem für Wellenlängen ≤ 100 nm, insbesondere im EUV-Bereich anzugeben, in dem die obengenannten Nachteile vermieden werden können.

Erfindungsgemäß wird diese Aufgabe durch ein Beleuchtungssystem nach einem der Ansprüche 1, 2 oder 4 gelöst.

Gitterelemente, beispielsweise Reflexionsgitter, insbesondere Echelette-Gitter, die auch als Blaze-Gitter bezeichnet werden, sind schon länger aus dem Monochromatorbau für Synchrotronstrahlungsquellen bekannt, wobei gute Erfahrungen insbesondere auch bei sehr hohen Flüssen vorliegen.

Betreffend den Einsatz von Beugungsgittern in Monochromatoren wird auf die nachfolgenden Druckschriften verwiesen:

- H.Petersen, C.Jung, C.Hellwig, W.B.Peatman, W.Gudat : "Review of plane grating focusing for soft x-ray monochromators", Rev.Sci.Instrum. 66(1), January 1995

- M.V.R.K.Murty: "Use of convergent and divergent illumination with plane gratings", Journal of the Optical Society of America, Vol.52, No.7, July 1962, S.768-773

- T.Oshio, E. Ishiguro, R.Iwanaga: "A theory of new astigmatism- and coma-free spectrometer", Nuclear Instruments and Methods 208 (1993) 297-301

Ein Beleuchtungssystem entsprechend der Präambel der Ansprüche 1, 2 und 4 ist in JP-A-07301696 offenbart.

Die Erfinder haben nun erkannt, daß ein Gitterelement im Strahlengang von der Objektebene zur Bildebene zur spektralen Filterung in einem Beleuchtungssystem für Wellenlängen ≤ 100 nm dann verwendet werden kann, wenn die einzelnen Beugungsordnungen und die Wellenlängen deutlich voneinander getrennt sind.

Dies ist für ein Gitterelement innerhalb eines konvergenten Strahlbüschels am einfachsten. Das konvergente Strahlbüschel weist einen Fokus mit einem begrenztem Durchmesser auf.

Um eine stigmatische Abbildung eines Objektes in die Ebene der physikalischen Blende mit einem Gitterelement im konvergenten Strahlengang zu erreichen, kann in einer ersten Ausführungsform der Erfindung vorgesehen sein, daß das optische Element in einer Meridionalebene konkav gekrümmt ist. Die Meridonalebene des optischen Elementes ist dabei definiert als die Ebene, welche senkrecht zur Trägerfläche des Gitterelementes und den Gitterlinien steht.

Alternativ oder ergänzend hierzu kann das optische Element in der Sagittalebene, die senkrecht auf der Trägerfläche und der Meridionalebene steht und den Mittelpunkt des Gitterelementes beinhaltet, konvex gekrümmt sein.

Wenn eine innere Beugungsordnung (k = 1, 2, 3) verwendet wird, ist die Brechkraft in meridonaler Richtung größer als in sagittaler Richtung, d.h. das Element ist z.B. in meridonaler Richtung konkav und in sagittaler Richtung plan oder in meridonaler Richtung plan und in sagittaler Richtung konvex oder in meridonaler Richtung konkav und in sagittaler Richtung konvex ausgebildet.

Bei Verwendung einer äußeren Beugungsordnung (k = -1, - 2, -3) ist die Brechkraft in sagittaler Richtung größer als in meridionaler Richtung, d.h. das Element ist in sagittaler Richtung konkav und in meridonaler Richtung plan oder in sagittaler Richtung plan und in meridonaler Richtung konvex oder in sagittaler Richtung konkav und in meridonaler Richtung konvex ausgebildet.

In vorliegender Anmeldung wird als innere Ordnung die Ordnung bezeichnet und mit positiven Zahlen belegt, die zur Flächennormalen hin gebeugt wird und als äußere Ordnung die Ordnung bezeichnet und mit negativen Zahlen belegt, die von der Flächennormalen weggebeugt wird.

In einer weiteren Ausführungsform der Erfindung kann vorgesehen sein, daß die stigmatische Abbildung durch eine Variation des Gitterlinienabstandes erreicht wird.

Die mindestens eine physikalische Blende gemäß der Erfindung dient im wesentlichen dazu, zu erreichen, daß Licht mit Wellenlängen weit oberhalb von 100 nm insbesondere durch Ausblenden der 0. Beugungsordnung nicht in das Beleuchtungssystem gelangt. Durch die eine physikalische Blende werden bevorzugt alle Beugungsordnungen außer einer Nutzordnung ausgeblendet. Die Nutzordnung kann beispielsweise die 1.Ordnung sein.

Besonders bevorzugt ist es, wenn durch die Kombination von Gitter und physikalischer Blende die Strahlen nach der physikalischen Blende Wellenlängen im Bereich von 7 bis 26 nm aufweisen.

Das Gitterelement ist bevorzugt als Blaze-Gitter ausgelegt, das auf eine maximale Effizienz in einer vorgegebenen Beugungsordnung optimiert ist. Blaze-Gitter sind beispielsweise aus Lexikon der Optik, herausgegeben von Heinz Haferkorn, VEB Bibliographisches Institut, Leipzig 1990, Seiten 48 bis 49, bekannt. Sie zeichnen sich durch ein annähernd dreieckförmiges Furchenprofil aus.

Um eine zu große Wärmelast auf der physikalischen Blende in der Blendenebene zu vermeiden, kann ein Teil der nicht gewünschten Strahlung durch weitere Blenden im Beleuchtungssystem herausgefiltert werden.

Neben dem Beleuchtungssystem stellt die Erfindung auch eine Projektionsbelichtungsanlage mit einem derartigen Beleuchtungssystem sowie ein Verfahren zur Herstellung von mikroelektronischen Bauteilen zur Verfügung.

Die Erfindung soll nachfolgend anhand der Figuren beispielhaft beschrieben werden. Es zeigen:

Figur 1: Anordnung eines Gitterelementes im Strahlengang der Kollektoreinheit eines Beleuchtungssystems
Figur 2: Gitterelement und physikalische Blende eines Beleuchtungssystems
Figur 3: Blaze-Gitter
Figur 4: maximal mögliche Beugungseffizienz für als Blaze-Gitter ausgelegte Gitterelemente
Figur 5: EUV-Projektionsbelichtungsanlage mit einem erfindungsgemäßen Beleuchtungssystem

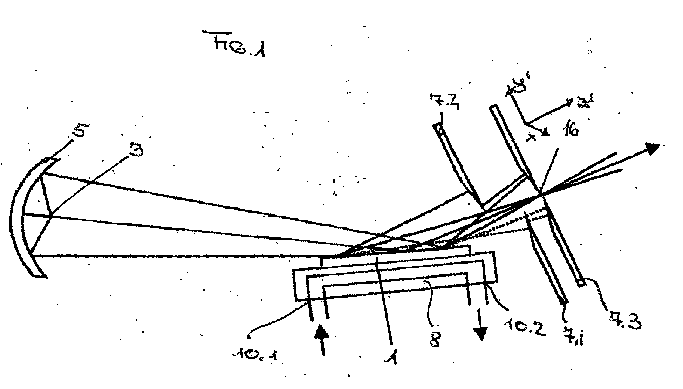

In Figur 1 ist ein Beleuchtungssystem mit einem Gitterelement 1 sowie einer physikalischen Blende in der Blendenebene gezeigt. Das Licht der Lichtquelle 3 wird bei den dargestellten Beleuchtungssystem von einer sammelnden Komponente, dem Kollektor 5 gesammelt. Der Kollektor 5 ist in diesem Beispiel ein ellipsoidförmiger Spiegel, welcher ein Bild der Lichtquelle 3 erzeugt. Das konvergente Lichtbüschel mit einer Apertur von etwa NA = 0.1 hinter dem Kollektor 5 wird über das Gitterelement 1 im streifenden Einfall so abgelenkt, daß in oder in der Nähe der Blendenebenen der physikalischen Blende 7.3 das Zwischenbild der Lichtquelle zum Liegen kommt.

Durch mehrere vor der physikalischen Blende 7.3 angeordneten Teilblenden 7.1, 7.2 kann bereits nicht gewünschte Strahlung herausgefiltert werden, um die Wärmelast auf der physikalischen Blende 7.3 mit der kreisförmigen Öffnung, welche sich in der Fokusebene der gewünschten Beugungsordnung, hier der -1. Ordnung 16, befindet, zu verringern. Die Blenden 7.1, 7.2 können zusätzlich gekühlt werden, was nicht dargestellt ist. Auch das Gitterelement 1 kann gekühlt sein, beispielsweise durch eine rückseitige Kühlung. Die rückseitige Kühleinrichtung 8 des Gitterelementes 1 ist bevorzugt eine Flüssigkühleinrichtung mit Zu- und Ablauf 10.1, 10.2. Durch das Gitterelement 1 und die physikalische Blende 7.3 gelingt es, die 0.Ordnung, die sämtliche Wellenlängen der Lichtquelle umfaßt, in dem erfindungsgemäßen Beleuchtungssystem vollständig zu blocken. Darüber hinaus werden auch alle anderen Ordnungen außer der -1. Ordnung blockiert.

Legt man bei einem Beleuchtungssystem mit Kollektor gemäß Figur 1 das Gitter als ebenes Gitter mit gleicher Gitterperiode aus, so ergibt sich eine astigmatische Abbildung der Lichtquelle. Um die Beugungsordnungen gut voneinander trennen zu können, ist eine stigmatische Abbildung der Lichtquelle 3 für eine Beugungsordnung, die nicht die 0. Beugungsordnung ist, in die Ebene der physikalischen Blende 7.3 erforderlich.

Man kann nun durch verschiedene Methoden versuchen, diesen Astigmatismus zu korrigieren, beispielsweise durch Einbringen zusätzlicher Brechkraft in der Meridionalebene oder Sagittalebene oder Variation des Gitterlinienabstandes.

Nachfolgend soll hierfür die Ableitung gegeben werden:

Ausgangspunkt für nachfolgende Betrachtung ist die Gittergleichung für ein paralleles Strahlenbündel:

$$N k \cdot \lambda = \sin \alpha + \sin \beta \qquad (1)$$

wobei N die Linienzahldichte, k die Beugungsordnung, $\lambda$ die Wellenlänge, $\alpha$ der Einfallswinkel und $\beta$ der Beugungswinkel (bezüglich der Flächennormalen der Trägerfläche und jeweils bezogen auf den Hauptstrahl $CR_{vor}$ bzw. $CR_{nach}$) ist. Die Nomenklatur, die bei der nachfolgenden Ableitung verwendet wird, orientiert sich an "Lexikon der Optik" in zwei Bänden, hrsg. H.Paul, Heidelberg, Berlin, Spektrum, Akad. Verlag 1999, Bd.1, A-L S.77-80.

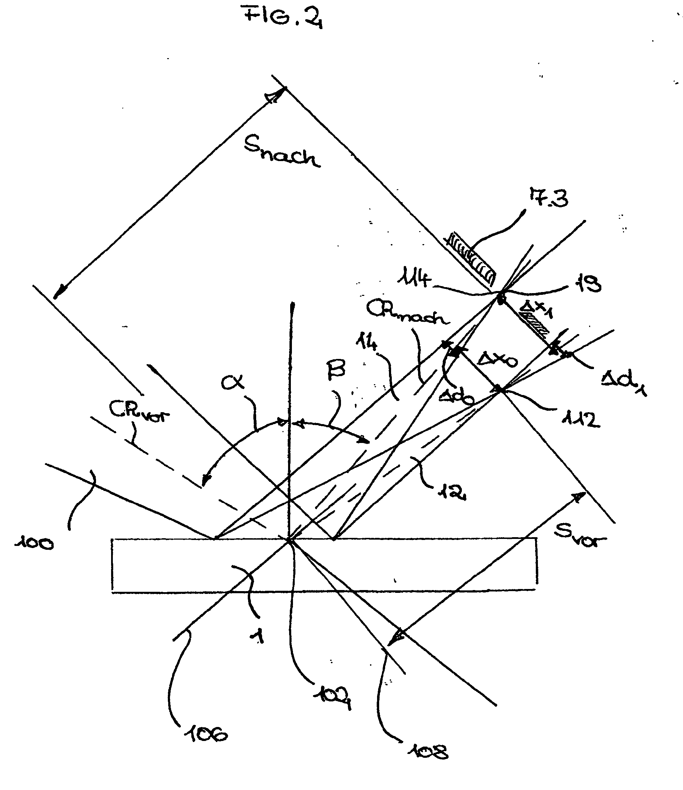

Zur Erläuterung der nachfolgenden Ableitung wird auf Figur 2 verwiesen.

Im in Figur 2 gezeigten Fall wird die konvergente Strahlung einer nicht gezeigten Lichtquelle durch das Gitterelement 1 spektral aufgespalten und am Zwischenfokus 19 durch die physikalische Blende 7.3 selektiert. Am Zwischenfokus 19 wird eine NA von 0,12 erreicht. In Figur 2 gezeigt ist ein konvergentes einfallendes Strahlbüschel 100. Dieses wird am Gitter 1 gebeugt. Dargestellt ist das in die 0.Beugungsordnung gebeugten Strahlbüschel 12 sowie das in die 1.Beugungsordnung gebeugte Strahlbüschel 14. Das in die 0.Beugungsordnung gebeugte Strahlbüschel hat einen Fokuspunkt 112 und das in die 1.Ordnung gebeugte Strahlbüschel einen Fokuspunkt 114. Durch den jeweiligen Fokuspunkt 112, 114 und den Auftreffpunkt 102 des Hauptstrahles $CR_{vor}$ des einfallenden Strahlbüschels 100 auf das Gitter 1 werden die Bildweiten $s_{vor}$ und $s_{nach}$ definiert. Hierbei bezeichnet $s_{vor}$ den Abstand des Auftreffpunktes 102 vom Fokuspunkt 112 des in die 0.Beugungsordnung gebeugten Strahlbüschels und $s_{nach}$ den Abstand des Auftreffpunktes 102 vom Fokuspunkt 114 des in die 1.Ordnung gebeugten Strahlbüschels 14. Der Winkel $\alpha$ bezeichnet den Einfallswinkel des Hauptstrahles $CR_{vor}$ des einfallenden Strahlbüschels bezüglich der Flächennormalen der Trägerfläche des Gitters 1 und $\beta$ den Beugungswinkel des Hauptstahles $CR_{nach}$ des in die 1.Ordnung gebeugten Strahlbüschels 14 bezüglich der Flächennormalen der Trägerfläche. Desweiteren eingezeichnet sind die Ebenen 106, 108 die im Auftreffpunkt 102 auf das Gitter 1 senkrecht auf dem Hauptstrahl $CR_{vor}$ des auftreffenden Strahlbüschels 100 und senkrecht auf dem Hauptstrahl $CR_{nach}$ des in die 1.Beugungsordnung gebeugten Strahlbüschels 14 stehen.

Betrachtet man nun im konvergenten Strahlengang eines Beleuchtungssystems ein Reflexionsgitter, das wie in Figur 2 gezeigt vor dem Zwischenfokus 19, der in vorliegendem Ausführungsbeispiel mit dem Fokuspunkt 114 des in die 1.Ordnung gebeugten Strahlbüschels zusammenfällt, plaziert ist, so muß die optische Wirkung des Gitters beachtet werden. Diese läßt sich aus der Erhaltung des Phasenraumvolumens bzw. des Lichtleitwertes oder der Etendue ableiten. Da der Beugungswinkel $\beta$ für Ordnungen ungleich der O. Ordnung ungleich dem Einfallswinkel $\alpha$ ist, verändert sich der Querschnitt des Strahlbüschels in der Ebene 106, 108, die senkrecht auf dem Hauptstrahl $CR_{vor}$ des einfallenden Strahlbüschels bzw. dem Hauptstrahl $CR_{nach}$ des gebeugten Starhlbüschels steht. Durch den vorgenannten Erhaltungssatz muß sich damit die Divergenz reziprok ändern. Das heißt, wird ein Gitter in der inneren Ordnung betrieben ($|\alpha| > |\beta|$), dann wird das Büschel um $\cos(\beta)/\cos(\alpha)$ größer und die Divergenz um denselben Faktor kleiner. Dadurch verlängert sich die Distanz bis zum Fokus bzw. Fokuspunkt um den quadratischen Faktor. Dieser Faktor wird nachfolgend als Fixfokuskonstante $C_{ff}$ bezeichnet:

$$c_{ff} = \cos(\beta)/\cos(\alpha) \qquad (2)$$

Damit ergibt sich für den Büschelquerschnitt am Gitter:

$$d_{nach} = d_{vor}\, c_{ff} \qquad (3)$$

bzw. für die numerische Apertur NA:

$$NA_{nach} = NA_{vor} / c_{ff} \qquad (4)$$

wobei $d_{nach}$ den Büschelquerschnitt des gebeugten Strahlbüschels 14 in der Ebene 108 und $d_{vor}$ den Büschelquerschnitt des einfallenden Strahlbüschels 100 in der Ebene 106, $NA_{nach}$ die numerische Apertur des gebeugten Strahlbüschels 14 und $NA_{vor}$ die numerische Apertur des einfallenden Strahlbüschels bezeichnet.

Für die Bildweite s wie zuvor definiert, gerechnet ab dem Gitter ergibt sich:

$$s_{nach} = s_{vor}\, c_{ff}^2. \qquad (5)$$

Zu beachten ist, daß das Gitter nur in der meridonalen bzw. dispersiven Richtung wirkt. Damit die Abbildung stigmatisch ist, ist es vorteilhaft zusätzlich eine optische Wirkung z.B. in sagittaler Richtung einzuführen.

Das kann zum Beispiel für den Fall, daß eine innere Beugungsordnung (k = 1, 2, 3) verwendet wird, durch eine konvexe Krümmung in sagittaler Richtung erreicht werden.

Für den Fall, daß eine äußere Beugungsordnung (k = -1,- 2, -3) verwendet wird, ist es vorteilhaft, daß das Gitter sagittal konkav gewählt wird.

Alternativ zu einem gekrümmten Gitter kann auch der Gitterlinienabstand variiert werden.

Für den Fall einer sagittal konvexen Krümmung muß der Radius so gewählt werden, daß aus der Bildweite $s_{vor}$ in der 0. Ordnung eine Bildweite von $S_{vor}C_{ff}^2$ wird. Über die Abbildungsgleichung kann man die sagittale Brennweite $f_s$ errechnen:

$$f_s = s_{vor} / (1 / c_{ff}^2 - 1) \qquad (6)$$

Zusammen mit dem Beugungswinkel ergibt sich schließlich der sagittale Radius zu:

$$R_s = f_s (\cos\alpha + \cos\beta) \qquad (7)$$

Im nachfolgenden soll an einem Ausführungsbeispiel abgeschätzt werden, wie ein Gitterelement 1 beschaffen sein muß, damit die nachfolgenden Bedingungen erfüllt sind:

- die Strahlbüschel der 0. und 1. Ordnung bzw. -1. Ordnung sind getrennt, d.h. am Fokuspunkt eines Strahlbüschels einer Beugungsordnung überlappt dieses Strahlbüschel nicht mit einem Strahlbüschels einer anderen Beugungsordnung
- die Nutzwellenlänge muß vom störenden Anteil getrennt sein
- die Distanz zum Zwischenfokus muß klein sein, damit das Gitter nicht zu groß wird
- die Beugungsgeometrie muß für beste Beugungseffizienz optimiert sein
- der Astigmatismus, der für die innere Ordnung eine defokussierende Wirkung und für die äußere Ordnung eine fokussierende Wirkung erzeugt, soll klein bleiben

Insbesondere die erste Bedingung entscheidet über die Effektivität des Gitterelementes. Eine Formel für die Abschätzung der Trennung der Strahlbüschel der verschiedenen Beugungsordnungen voneinander läßt sich unter Bezugnahme auf Figur 2 wie folgt ableiten. So ergibt sich der Abstand $\Delta x_0$ der Hauptstrahlen der Strahlbüschel unterschiedlicher Beugungsordnung am Fokuspunkt der 0. Ordnung aus den Beugungswinkeln:

$$\Delta x_0 = s_{vor} \sin (\alpha + \beta) \qquad (8)$$

und der Abstand $\Delta x_1$ am Fokuspunkt der Beugungsordnung:

$$\Delta x_1 = s_{vor} c_{ff}^2 \sin (\alpha + \beta). \qquad (9)$$

Da das jeweils andere Strahlbüschel nicht fokussiert ist, also eine Ausdehnung besitzt, ist es zur Abschätzung, ob die Strahlbüschel im Fokuspunkt nicht überlappen, notwendig, die Ausdehnung des anderen Strahlbüschels abzuschätzen. Dies kann über die Divergenz bzw. die numerische Apertur abgeschätzt werden. Für die Ausdehnung des Strahlbüschels der 0. Ordnung am Fokuspunkt der Beugungsordnung ergibt sich:

$$\Delta d_1 = 2 \, NA \, c_{ff} \, |s_{vor} \, c_{ff}^2 - s_{vor}|. \qquad (10)$$

und für die Ausdehnung des Strahlbüschels der 1. Ordnung bzw. der -1. Ordnung am Fokuspunkt der 1.Ordnung bzw. -1.Ordnung:

$$\Delta d_0 = 2 \, NA \, |s_{vor} c_{ff}^2 - s_{vor}|. \qquad (11)$$

Die Differenz von z.B. $\Delta x_0$ und $\Delta d_0/2$ ergibt z.B. den Abstand der Randstrahlen des gebeugten Strahlbüschels vom Fokuspunkt des Strahlbüschels der 0. Ordnung. Um einen Überlapp von verschiedenen Strahlbüschel zu verhindern sollte dieser Abstand mindestens dem halben Durchmesser des Strahlbüschels im Fokuspunkt, der mit $\Delta x_f$ bezeichnet wird, entsprechen; dann wird eine ausreichende Trennung der Strahlbüschel der 0. Beugungsordnung von den Strahlbüscheln anderer Beugungsordnungen erreicht.

Es soll also gelten:

$$s_{vor} \sin(\alpha + \beta) - NA \, |s_{vor} \, c_{ff}^2 - s_{vor}| > \Delta x_f \qquad (12)$$

oder

$$s_{vor} \, c_{ff}^2 \sin(\alpha + \beta) - NA \, c_{ff} \, |s_{vor} \, c_{ff}^2 - s_{vor}| \, c_{ff} > \Delta x_f \qquad (13)$$

Mit den obengenannten Überlegungen und Formeln läßt sich das, durch die nachfolgenden in Tabelle 1 angegebenen Größen charakterisierte, Gitterelement mit sagittaler konvexer Krümmung konstruieren, das sich durch eine Gittereffizienz von 56 % auszeichnet.

Tabelle 1: Charakteristische Größen eines Gitterelementes mit konvexer Querkrümmung.

| | | |
|---|---|---|
| Wellenlänge | 13,4 | nm |
| Photonenenergie | 92,5 | eV |
| Linienzahl | 1600 | 1/mm |
| Beugungsordnung | 1 | |
| Fixfokuskonstante $C_{ff}$ | 1,2 | |
| Inzidenzwinkel $\alpha$ des Hauptstrahles $CR_{vor}$ | 72,360 | Grad |
| Beugungswinkel $\beta$ des in die 1.Ordnung gebeugten Haupstrahles $CR_{nach}$ | -68,676 | Grad |
| Blazetiefe | 20,1 | nm |
| Abstand Gitter-Fokus | 432 | mm |
| sagittaler Radius | 654,555 | mm |
| NA (nach Gitter) | 0,12 | |
| Gitterlänge | 237 | mm |
| Belegung | Ru | |
| Mikrorauhigkeit | 0,5 | nm (rms) |
| Gittereffizienz | 56 | % |

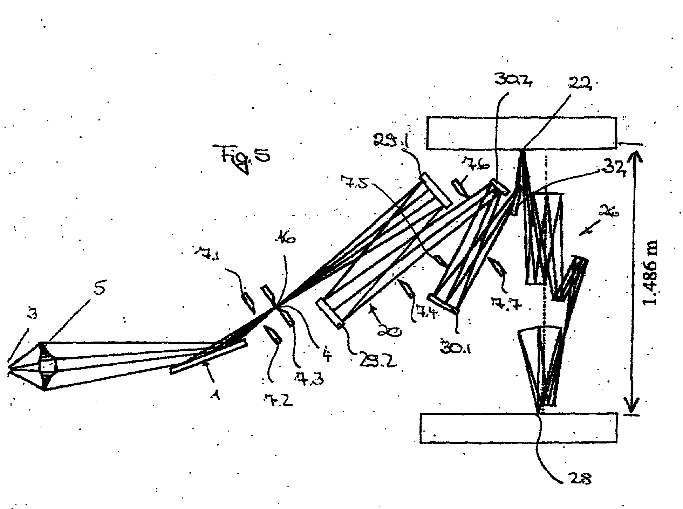

Mit dem Gitterelement 1 gemäß Ausführungsbeispiel in Tabelle 1 in Kombination mit einer Blende können Wellenlängen oberhalb von etwa 18 nm und unterhalb 8 nm beinahe vollständig herausgefiltert werden. Hierdurch kann die Wärmelast auf den Spiegel eines Projektionssystems deutlich reduziert werden.
Um ein Gitterelement 1 mit optimaler Beugungseffizienz zu erhalten, wird das Gitterelement bevorzugt als Blaze-Gitter ausgebildet.

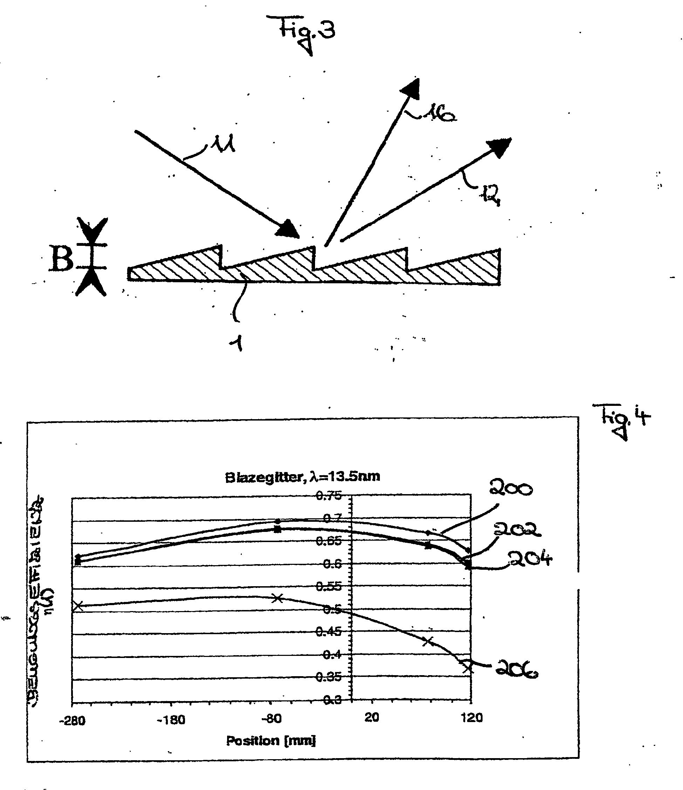

In Figur 3 ist ein Blaze-Gitter mit annähernd dreieckförmigen Furchenprofil gezeigt. Die Bezugsziffer 11 bezeichnet den auf das als Blaze-Gitter ausgelegten Gitterelementes 1 auftreffenden Strahl; 12 den am Gitter in die 0.Ordnung reflektierten und 16 den in die 1.Ordnung gebeugten Strahl. Die Blaze-Tiefe B ist eine Funktion der Einfalls- und Ausfallwinkel. Daher ist es vorteilhaft, wenn zur Erreichung einer maximalen Beugungseffizienz bei einem konvergenten Strahlbüschel sich in Abhängigkeit von der Position auf dem Gitter die Blaze-Tiefe ändert.
Verwendet man ein derartiges Gitterelement, dessen lokale Blaze-Tiefe B sich mit der Position auf dem Gitter ändert, so erhält man eine maximale Effizienz gemäß Figur 4. Wie Figur 4 zeigt, hängt die Beugungseffizienz $\eta(1)$ von den verwendeten Materialien ab.
In Figur 4 bezeichnet Bezugsziffer 200 die Beugungseffizienz $\eta(1)$ bei einer Wellenlänge von $\lambda$ = 13,5 nm für Ruthenium, Bezugsziffer 202 für Palladium, Bezugsziffer 204 für Rhodium und Bezugsziffer 206 für Gold.
Wie aus Figur 4 hervorgeht, ist mit Ruthenium die höchste Effizienz von 0,7 zu erreichen. Eine Beschichtung aus Palladium oder Rhodium, die bessere Langzeiteigenschaften aufweist, weist aber nur eine um 3 % schlechtere Effizienz η(1) von 0,67 auf. Gold wird üblicherweise bei Synchrotrongittern verwendet, hat aber, wie aus der Kurve 206 hervorgeht, bei λ = 13,5 nm eine deutlich schlechtere Effizienz als die vorgenannten Materialien.

In Figur 5 ist eine EUV-Projektionsbelichtungsanlage mit einem erfindungsgemäßen Gitterelement 1 gezeigt. Die EUV-Projektionsbelichtungsanlage umfaßt eine Lichtquelle 3, ein sammelnde optische Komponente, einen sog. Kollektor 5, der als genesteter Kollektor gemäß der deutschen Patentanmeldung DE-A-10102934, eingereicht am 23.01.2001, beim Deutschen Patentamt für die Anmelderin, ausgebildet ist. Der Kollektor 5 bildet die in der Objektebene des Beleuchtungssystemes liegende Lichtquelle 3 in eine sekundäre Lichtquelle 4 in oder in der Nähe einer Blendenebene 7.3 ab.

Vorliegend ist die Lichtquelle 3, die beispielsweise eine Laser-Plasma-Quelle oder eine Plasma-Entladungsquelle sein kann, in der Objektebene des Beleuchtungssystems angeordnet; in der Blendenebene 7.3 des Beleuchtungssystems kommt das Bild der primären Lichtquelle zum Liegen, die auch als sekundäre Lichtquelle bezeichnet wird.

Zwischen Gitterelement 1 und der physikalischen Blende 7.3 sind zusätzliche Blenden 7.1, 7.2 angeordnet, um das Licht ungewünschter Wellenlängen, insbesondere Wellenlängen größer als 30 nm, abzublocken. Erfindungsgemäß kommt in der Ebene der Blende 7.3 der Fokus der 1.Ordnung zu Liegen, d.h. die Lichtquelle 3 wird durch Kollektor und Gitterspektralfilter in der 1. Beugungsordnung nahezu stigmatisch in die Ebene der Blende 7.3 abgebildet. Die Abbildung in alle anderen Beugungsordnungen ist nicht stigmatisch.

Des weiteren umfaßt das Beleuchtungssystem des Projektionssystems ein optisches System 20 zur Formung und Ausleuchtung der Feldebene 22 mit einem ringförmigen Feld. Das optische System umfaßt als Mischeinheit zur homogenen Ausleuchtung des Feldes zwei Facettenspiegel 29.1, 29.2 sowie zwei abbildende Spiegel 30.1, 30.2 und einen feldformenden grazing-incidence Spiegel 32. Im optischen System 20 sind zusätzliche Blenden 7.4, 7.5, 7.6, 7.7 zur Unterdrückung von Falschlicht angeordnet.

Der erste Facettenspiegel 29.1, der sogenannte Feldfacettenspiegel, erzeugt eine Vielzahl von sekundären Lichtquellen in oder in der Nähe der Ebene des zweiten Facettenspiegels 29.2, dem sogenannten Pupillenfacettenspiegel. Die nachfolgende Abbildungsoptik bildet den Pupillenfacettenspiegel 29.2 in die Austrittspupille des Beleuchtungssystems ab, welche in der Eintrittspupille des Projektionsobjektives 26 zum Liegen kommt. Die Neigungswinkel der einzelnen Facetten der ersten und zweiten Facettenspiegel 29.1, 29.2 sind dabei so ausgelegt, daß sich die Bilder der einzelne Feldfacetten des ersten Facettenspiegels 29.1 in der Feldebene 22 des Beleuchtungssystems überlagern und somit eine weitgehend homogenisierte Ausleuchtung der strukturtragenden Maske, welche in dieser Feldebene 22 zum Liegen kommt, ermöglicht wird. Das Segment des Ringfeldes wird über den unter streifenden Einfall betriebenen feldformenden grazing-incidence Spiegel 32 ausgebildet.

Ein doppelt facettiertes Beleuchtungssystem ist beispielsweise in dem US-Patent US-B-6198793 offenbart, abbildende und feldformende Komponenten in der PCT/EP/00/07258.

Die in der Feldebene 22 angeordnete strukturtragende Maske, die auch als Retikel bezeichnet wird, wird mit Hilfe eines Projektionsobjektives 26 in die Bildebene 28 der Feldebene 22 abgebildet wird. Das Projektionsobjektiv 26 ist ein 6-Spiegel-Projektionsobjektiv wie beispielsweise in der US-Anmeldung 60/255214 eingereicht am 13.12.2000 beim US-Patentamt für die Anmelderin bzw. der DE-A-10037870 offenbart. In der Bildebene 28 ist das zu belichtende Objekt, beispielsweise ein Wafer, angeordnet.

Als Fertigungsmöglichkeit für ein erfindungsgemäßes Gitterelement kommt beispielsweise die Replikatechnik in Betracht.

Mit der Erfindung wird erstmals ein Beleuchtungssystem angegeben, mit dem unerwünschte Wellenlängen direkt nach der Lichtquelleneinheit selektiert werden können und das eine Alternative zu Filterfolien darstellt, die insbesondere hinsichtlich der Wärmebelastung problematisch sind.

Bezugszeichenliste

| | |
|---|---|
| 1 | Gitterelement |
| 3 | Lichtquelle |
| 5 | Kollektor |
| 7.1, 7.2, 7.3 | |
| 7.4, 7.5, 7.6 | |
| 7.7 | Blenden |
| 8 | Kühleinrichtung |
| 10.1, 10.2 | Zu- und Ablauf der Kühleinrichtung |
| 11 | auftreffende Strahlung |
| 12 | 0. Ordnung der Nutzwellenfläche |

| 14 | 1. Ordnung der Nutzwellenfläche |
|---|---|
| 16 | -1. Ordnung der Nutzwellenfläche |
| 20 | optisches System |
| 22 | Feldebene |
| 26 | Projektionsobjektiv |
| 28 | Bildebene der Feldebene |
| 29.1, 29.2 | Facettenspiegel |
| 30.1, 30.2 | abbildende Spiegel |
| 32 | feldformende Spiegel |
| 34 | Austrittspupille des Beleuchtungssystems |
| 100 | konvergent einfallendes Strahlbüschel |
| 102 | Auftreffpunkt des Hauptstrahles $CR_{vor}$ auf das Gitter 1 |
| 106 | Ebene, die senkrecht auf dem Hauptstrahl $CR_{vor}$ steht |
| 108 | Ebene, die senkrecht auf dem Hauptstrahl $CR_{nach}$ steht |
| 112 | Fokuspunkt des in die Ordnung gebeugten Strahlbüschels |
| 114 | Fokuspunkt des in die 1.Ordnung gebeugten Strahlbüschels |
| 200, 202, 204, 206 | Beugungseffizienz $\eta(1)$ für unterschiedliche Materialien |

**Patentansprüche**

1. Beleuchtungssystem insbesondere für Wellenlängen $\leq$ 100 nm mit einer Objektebene und einer Feldebene (22), wobei das Beleuchtungssystem umfasst:

- mindestens ein Gitterelement (1) sowie
- mindestens eine physikalische Blende (7.3) in einer Blendenebene, die dem Gitterelement im Strahlengang von der Objektebene zur Feldebene (22) nachgeordnet ist,

**dadurch gekennzeichnet, dass**

- das Beleuchtungssystem eine Kollektoreinheit (5) zur Erzeugung eines konvergenten Lichtbündels aufweist und das konvergente Lichtbündel auf das Gitterelement (1) trifft, wobei der Abstand der Gitterlinien des Gitterelementes variiert und der Abstand der Gitterlinien mit größer werdendem Einfallswinkel der Strahlen des einfallenden Lichtbüschels abnimmt.

2. Beleuchtungssystem insbesondere für Wellenlängen $\leq$ 100 nm mit einer Objektebene und einer Feldebene (22), wobei das Beleuchtungssystem umfasst:

- mindestens ein Gitterelement (1) sowie
- mindestens eine physikalische Blende (7.3) in einer Blendenebene, die dem Gitterelement im Strahlengang von der Objektebene zur Feldebene (22) nachgeordnet ist,

**dadurch gekennzeichnet, dass**

- das Beleuchtungssystem eine Kollektoreinheit (5) zur Erzeugung eines konvergenten Lichtbündels aufweist und das konvergente Lichtbündel auf das Gitterelement (1) trifft, wobei eine Meridionalebene für das Gitterelement mit Gitterlinien gegeben ist, welche senkrecht auf einer Trägerfläche des Gitterelementes und senkrecht zu den Gitterlinien steht und die Trägerfläche des Gitterelementes in der Meridionalebene konkav oder konvex gekrümmt ist.

3. Beleuchtungssystem nach Anspruch 2,
**dadurch gekennzeichnet, dass**
eine Sagittalebene für das Gitterelement mit Gitterlinien gegeben ist,
welche senkrecht auf einer Trägerfläche des Gitterelementes und parallel zu den Gitterlinien steht und den Mittelpunkt des Gitterelementes beinhaltet und dass das Gitterelement in der Sagittalebene konvex oder konkav gekrümmt ist.

4. Beleuchtungssystem insbesondere für Wellenlängen ≤ 100 nm mit einer Objektebene und einer Feldebene (22), wobei das Beleuchtungssystem umfasst:

   - mindestens ein Gitterelement (1) sowie
   - mindestens eine physikalische Blende (7.3) in einer Blendenebene, die dem Gitterelement im Strahlengang von der Objektebene zur Feldebene (22) nachgeordnet ist,

   **dadurch gekennzeichnet, dass**

   - das Beleuchtungssystem eine Kollektoreinheit (5) zur Erzeugung eines konvergenten Lichtbündels aufweist und das konvergente Lichtbündel auf das Gitterelement (1) trifft, wobei eine Sagittalebene für das Gitterelement mit Gitterlinien gegeben ist, welche senkrecht auf einer Trägerfläche des Gitterelementes und parallel zu den Gitterlinien steht und den Mittelpunkt des Gitterelementes beinhaltet und dass das Gitterelement in der Sagittalebene konvex oder konkav gekrümmt ist.

5. Beleuchtungssystem nach einem der Ansprüche 1 bis 4, **dadurch gekennzeichnet, dass** das Gitterelement (1) derart ausgestaltet ist, dass es Strahlbüschel (12, 14) unterschiedlicher Beugungsordnung mit je einem Fokuspunkt (112, 114) erzeugt und dass der Fokuspunkt eines Strahlbüschels einer k.-ten Beugungsordnung des Gitterelementes am Ort der mindestens einen physikalischen Blende (7.3) zu liegen kommt, wobei | k | ≥ 1 ist.

6. Beleuchtungssystem gemäß Anspruch 5, **dadurch gekennzeichnet, dass** die mindestens eine physikalische Blende (7.3) Strahlen des Strahlbüschels der k.-ten Beugungsordnung des Gitterelementes durchlässt, und alle Strahlen von Strahlbüscheln einer m.-ten Beugungsordnung zu mehr als 90 % blockiert, wobei m ≠ k ist.

7. Beleuchtungssystem gemäß einem der Ansprüche 1 bis 6, **dadurch gekennzeichnet, dass** die Strahlen des Strahlbüschels nach der physikalischen Blende (7.3) Wellenlängen im Bereich 7 - 26 nm aufweisen.

8. Beleuchtungssystem gemäß einem der Ansprüche 1 bis 7, **dadurch gekennzeichnet, dass** das Gitterelement ein Blaze-Gitter ist.

9. Beleuchtungssystem nach einem der Ansprüche 1 bis 8, **dadurch gekennzeichnet, dass** in der Objektebene des Beleuchtungssystems eine primäre Lichtquelle (3), vorzugsweise eine Laser-Plasma-Quelle, angeordnet ist, die in eine sekundäre Lichtquelle (4) am Ort der physikalischen Blende (7.3) des Beleuchtungssystemes abgebildet wird.

10. Beleuchtungssystem nach einem der Ansprüche 1 bis 9, **dadurch gekennzeichnet, dass** das Beleuchtungssystem zwischen der Blendenebene mit der physikalischen Blende und der Feldebene (22) ein optisches System (20) zur Formung und Ausleuchtung eines Feldes in der Feldebene umfasst.

11. Beleuchtungssystem nach Anspruch 10, **dadurch gekennzeichnet, dass** das optische System (20) eine Mischeinheit zur homogenen Ausleuchtung des Feldes umfasst.

12. Beleuchtungssystem nach Anspruch 11, **dadurch gekennzeichnet, dass** die Mischeinheit zwei Facettenspiegel (29.1, 29.2) umfasst.

13. Beleuchtungssystem nach einem der Ansprüche 10 bis 12, **dadurch gekennzeichnet, dass** das Feld ein Segment eines Ringfeldes ist und das optische System feldformende Komponenten (32) umfasst.

14. Beleuchtungssystem nach einem der Ansprüche 1 bis 13, **dadurch gekennzeichnet, dass** das Beleuchtungssystem weitere Blenden (7.1, 7.2) im Strahlengang zwischen Objektebene und der Blendenebene (7.3) umfasst.

15. Beleuchtungssystem nach einem der Ansprüche 1 bis 14, **dadurch gekennzeichnet, dass** das optische System (20) Blenden (7.4, 7.5, 7.6, 7.7) zur Unterdrückung von Falschlicht umfasst.

16. Projektionsbelichtungsanlage zur Herstellung von mikroelektronischen Bauteilen mit

einem Beleuchtungssystem gemäß einem der Ansprüche 1 bis 15
einer strukturtragenden Maske
einem Projektionsobjektiv (26)
einem lichtsensitiven Objekt, wobei die strukturtragende Maske auf das lichtsensitive Objekt abgebildet wird.

17. Verfahren zur Herstellung von mikroelektronischen Bauteilen, insbesondere Halbleiter-Bauteilen mit einer Projektionsbelichtungsanlage gemäß Anspruch 16.


**Claims**

1. Illuminator system in particular for wavelengths ≤ 100 nm with an object plane and a field plane (22) wherein the illuminator system comprises

    - at least one grating element (1) and
    - at least one physical stop (7.3) in a stop plane disposed after the grating element in the beam path from the object plane to the field plane (22)

    **characterised in that**

    - the illuminator system comprises a collector unit (5) for producing a convergent light beam and **in that** the convergent light beam is incident on the grating element (1), wherein the distance between the grating lines in the grating element varies and the distance between the grating lines decreases with increasing angle of incidence of the rays of the incident light.

2. Illuminator system in particular for wavelengths ≤ 100 nm with an object plane and a field plane (22) wherein the illuminator system comprises

    - at least one grating element (1) and
    - at least one physical stop (7.3) in a stop plane disposed after the grating element in the beam path from the object plane to the field plane (22)

    **characterised in that**

    - the illuminator system comprises a collector unit (5) for producing a convergent light beam and **in that** the convergent light beam is incident on the grating element (1), wherein there is a meridional plane for the grating element with grating lines that stands perpendicular to one bearing surface of the grating element and perpendicular to the grating lines and wherein the bearing surface of the grating element in the meridional plane is curved in a concave or convex form.

3. Illuminator system according to claim 2, **characterised in that**
   there is a sagittal plane for the grating element with grating lines that stands perpendicular to one bearing surface of the grating element and parallel to the grating lines and includes the centre point of the grating element and **in that** the grating element in the sagittal plane is curved in a convex or concave form.

4. Illuminator system in particular for wavelengths ≤ 100 nm with an object plane and a field plane (22) wherein the illuminator system comprises

    - at least one grating element (1) and
    - at least one physical stop (7.3) in a stop plane disposed after the grating element in the beam path from the object plane to the field plane (22)

    **characterised in that**

    - the illuminator system comprises a collector unit (5) for producing a convergent light beam and **in that** the convergent light beam is incident on the grating element (1), wherein there is a sagittal plane for the grating element with grating lines that stands perpendicular to one bearing surface of the grating element and parallel to the grating lines and includes the centre point of the grating element and **in that** the grating element in the sagittal plane is curved in a convex or concave form.

5.  Illuminator system in accordance with one of the claims 1 to 4, **characterised in that** the grating element (1) is embodied in such a way that it generates light rays (12, 14) of differing orders of diffraction each having a focus point (112, 114) and **in that** the focus point of the light beam of the kth order of diffraction of the grating element comes to lie at the location of the at least one physical stop (7.3), wherein |k| is $\geq$ 1.

6.  Illuminator system according to claim 5, **characterised in that**
the at least one physical stop (7.3) allows the rays of the kth order of diffraction of the grating element to pass and blocks more than 90% of all the rays of the mth order of diffraction, wherein m is $\neq$ k.

7.  Illuminator system according to one of the claims 1 to 6, **characterised in that**
the light rays after the physical stop (7.3) have wavelengths in the range 7 - 26 nm.

8.  Illuminator system according to one of the claims 1 to 7, **characterised in that**
the grating element is a blazed element.

9.  Illuminator system according to one of the claims 1 to 8, **characterised in that**
a primary light source (3), preferably a laser-plasma source, is disposed in the object plane of the illuminator system, with said light source being mapped onto a secondary light source (4) at the location of the physical stop (7.3) of the illuminator system.

10. Illuminator system according to one of the claims 1 to 9, **characterised in that**
the illuminator system comprises an optical system (20) between the stop plane with the physical stop and the field plane (22) for forming and illuminating a field in the field plane.

11. Illuminator system according to claim 10, **characterised in that** the optical system (20) comprises a mixer unit for the homogenous illumination of the field.

12. Illuminator system according to claim 11, **characterised in that** the mixer unit comprises two facette mirrors (29.1, 29.2).

13. Illuminator system according to one of the claims 10 to 12, **characterised in that** the field is a segment of an annular field and the optical system comprises field-forming components (32).

14. Illuminator system according to one of the claims 1 to 13, **characterised in that** the illuminator system comprises further stops (7.1, 7.2) in the path of the rays between the object plane and the stop plane (7.3).

15. Illuminator system according to one of the claims 1 to 14 **characterised in that** the optical system (20) comprises stops (7.4, 7.5, 7.6, 7.7) to suppress stray light.

16. Projection lighting system for the production of microelectronic components with
an illuminator system according to one of the claims 1 to 15
a structure-bearing mask
a projection lens (26)
a light-sensitive subject, wherein the structure-bearing mask is mapped onto the light-sensitive object.

17. Method for the manufacture of microelectronic components, more particularly semiconductor components using a projection lighting system according to claim 16.

**Revendications**

1.  Système d'éclairage en particulier pour des longueurs d'onde $\leq$ 100 nm comprenant un plan d'objet et un plan de champ (22), le système d'éclairage comprenant :

    - au moins un élément de grille (1) et
    - au moins un diaphragme (7.3) physique dans un plan de diaphragme, qui est placé en aval de l'élément de grille dans la trajectoire des rayons allant du plan d'objet vers le plan de champ (22),

**caractérisé en ce que** :

- le système d'éclairage présente une unité collectrice (5) pour générer un faisceau lumineux convergent et le faisceau lumineux convergent arrive sur l'élément de grille (1), l'espacement des lignes de grille de l'élément de grille variant et l'espacement des lignes de grille diminuant avec un angle d'incidence croissant des rayons du faisceau de lumière incident.

2. Système d'éclairage en particulier pour des longueurs d'onde ≤ 100 nm comprenant un plan d'objet et un plan de champ (22), le système d'éclairage comprenant :

- au moins un élément de grille (1) et
- au moins un diaphragme (7.3) physique dans un plan de diaphragme, qui est placé en aval de l'élément de grille dans la trajectoire des rayons allant du plan d'objet vers le plan de champ (22),

**caractérisé en ce que** :

- le système d'éclairage présente une unité collectrice (5) pour générer un faisceau de lumière convergent et le faisceau de lumière convergent arrive sur l'élément de grille (1), un plan méridional étant donné pour l'élément de grille avec des lignes de grille, lequel est perpendiculaire sur une surface support de l'élément de grille et perpendiculaire aux lignes de grille et la surface support de l'élément de grille étant incurvée de façon concave ou convexe dans le plan méridional.

3. Système d'éclairage selon la revendication 2,
**caractérisé en ce que** :

un plan sagittal est présent pour l'élément de grille avec des lignes de grille, qui est perpendiculaire sur une surface support de l'élément de grille et parallèle aux lignes de grille et contient le centre de l'élément de grille et **en ce que** l'élément de grille est courbé de façon convexe ou concave dans le plan sagittal.

4. Système d'éclairage en particulier pour des longueurs d'onde ≤ 100 nm comprenant un plan d'objet et un plan de champ (22), le système d'éclairage comprenant :

- au moins un élément de grille (1), et
- au moins un diaphragme (7.3) physique dans un plan de diaphragme, qui est placé en aval de l'élément de grille dans la trajectoire des rayons du plan d'objet vers le plan de champ (22),

**caractérisé en ce que** :

- le système d'éclairage présente une unité collectrice (5) pour générer un faisceau lumineux convergent et le faisceau lumineux convergent arrive sur l'élément de grille (1), un plan sagittal étant présent pour l'élément de grille avec des lignes de grille, qui est perpendiculaire sur une surface support de l'élément de grille et parallèle aux lignes de grille et contient le centre de l'élément de grille et **en ce que** l'élément de grille est courbé de façon convexe ou concave dans le plan sagittal.

5. Système d'éclairage selon l'une quelconque des revendications 1 à 4, **caractérisé en ce que** l'élément de grille (1) est conçu de telle sorte qu'il génère des faisceaux de rayons (12, 14) d'ordre de diffraction différent avec à chaque fois un foyer (112, 114) et **en ce que** le foyer d'un faisceau de rayons d'un k-ième ordre de diffraction de l'élément de grille est disposé à l'emplacement du au moins un diaphragme (7.3) physique, sachant que | k | ≥ 1.

6. Système d'éclairage selon la revendication 5, **caractérisé en ce que** le au moins un diaphragme (7.3) physique laisse passer des rayons du faisceau de rayons du k-ième ordre de diffraction de l'élément de grille, et bloque tous les rayons de faisceaux de rayons d'un m-ième ordre de diffraction pour plus de 90 %, sachant que m est ≠ k.

7. Système d'éclairage selon l'une quelconque des revendications 1 à 6, **caractérisé en ce que** les rayons du faisceau de rayons après le diaphragme (7.3) physique présentent des longueurs d'onde de l'ordre 7 à 26 nm.

**8.** Système d'éclairage selon l'une quelconque des revendications 1 à 7, **caractérisé en ce que** l'élément de grille est un réseau blaze.

**9.** Système d'éclairage selon l'une quelconque des revendications 1 à 8, **caractérisé en ce que** dans le plan d'objet du système d'éclairage est disposée une source de lumière (3) primaire, de préférence une source de plasma créé par le faisceau laser, qui est reproduite dans une source de lumière (4) secondaire à l'emplacement du diaphragme (7.3) physique du système d'éclairage.

**10.** Système d'éclairage selon l'une quelconque des revendications 1 à 9, **caractérisé en ce que** le système d'éclairage entre le plan de diaphragme avec le diaphragme physique et le plan de champ (22) comprend un système (20) optique pour la formation et l'éclairage d'un champ dans le plan de champ.

**11.** Système d'éclairage selon la revendication 10, **caractérisé en ce que** le système (20) optique comprend une unité de mélange pour l'éclairage homogène du champ.

**12.** Système d'éclairage selon la revendication 11, **caractérisé en ce que** l'unité de mélange comprend deux miroirs à facettes (29.1, 29.2).

**13.** Système d'éclairage selon l'une quelconque des revendications 10 à 12, **caractérisé en ce que** le champ est un segment d'un champ annulaire et le système optique comprend des composants (32) formant le champ.

**14.** Système d'éclairage selon l'une quelconque des revendications 1 à 13, **caractérisé en ce que** le système d'éclairage comprend d'autres diaphragmes (7.1, 7.2) dans la trajectoire de rayons entre le plan d'objet et le plan de diaphragme (7.3).

**15.** Système d'éclairage selon l'une quelconque des revendications 1 à 14, **caractérisé en ce que** le système (20) optique comprend des diaphragmes (7.4, 7.5, 7.6, 7.7) pour la suppression de la lumière parasite.

**16.** Installation d'exposition de projection pour la fabrication de composants de microélectronique comprenant un système d'éclairage selon l'une quelconque des revendications 1 à 15, un masque portant la structure, un objectif de projection (26), un objet sensible à la lumière, le masque portant la structure étant reproduit sur l'objet sensible à la lumière.

**17.** Procédé pour fabriquer des composants de microélectronique, en particulier des composants à semiconducteurs avec une installation d'exposition de projection selon la revendication 16.

FIG. 1

FIG. 2

Fig.3

B

*11*

*16*

*12*

*1*

Fig.4

**Blazegitter, λ=13.5nm**

*200*

*202*

*204*

*206*

η(λ)

Position [mm]

-280    -180    -80    20    120

0.75
0.7
0.65
0.6
0.55
0.5
0.45
0.4
0.35
0.3

Fig.5

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- JP 07301696 A
- DE 10102934 A
- US 6198793 B
- EP 0007258 W
- US 60255214 B
- DE 10037870 A

### In der Beschreibung aufgeführte Nicht-Patentliteratur

- **H.PETERSEN ; C.JUNG ; C.HELLWIG ; W.B.PEATMAN ; W.GUDAT.** Review of plane grating focusing for soft x-ray monochromators. *Rev.Sci.Instrum.,* Januar 1995, vol. 66 (1
- **M.V.R.K.MURTY.** Use of convergent and divergent illumination with plane gratings. *Journal of the Optical Society of America,* 07. Juli 1962, vol. 52, 768-773
- **T.OSHIO ; E. ISHIGURO ; R.IWANAGA.** A theory of new astigmatism- and coma-free spectrometer. *Nuclear Instruments and Methods,* 1993, vol. 208, 297-301
- **HEINZ HAFERKORN.** *VEB Bibliographisches Institut,* 1990, 48-49
- **H.PAUL.** *Heidelberg,* 1999, vol. 1, 77-80